# EUROPÄISCHE PATENTSCHRIFT

(11) **EP 1 060 521 B1**
(45) Veröffentlichungstag und Bekanntmachung des Hinweises auf die Patenterteilung: **23.10.2002**
(21) Anmeldenummer: 99913156.8
(22) Anmeldetag: 11.02.1999
(51) Int. Cl.: H01L 39/14

(54) **MEHRKERN-BSCCO-HOCHTEMPERATUR-SUPRALEITER**
MULTI-CORE BSCCO HIGH-TEMPERATURE SUPERCONDUCTOR
SUPRACONDUCTEUR A HAUTE TEMPERATURE BSCCO A PLUSIEURS NOYAUX

(30) Priorität: 03.03.1998 DE 19808834
(43) Veröffentlichungstag der Anmeldung: 20.12.2000
(73) Patentinhaber: Forschungszentrum Karlsruhe GmbH, 76133 Karlsruhe (DE)
(72) Erfinder: GOLDACKER, Wilfried, D-69121 Heidelberg (DE)
(74) Vertreter: Rückert, Friedrich, Dr.
(86) Internationale Anmeldenummer: EP9900894
(87) Internationale Veröffentlichungsnummer: WO99045597

(56) Entgegenhaltungen:
- WO-A-96/28853

## Beschreibung

Die Erfindung betrifft einen Mehrkern-BSCCO-Hochtemperatur-Supraleiter, bei dem die jeweils silberumhüllten Supraleiter-Filamente durch eine resistive Materialschicht, eine resistive Barriere, voneinander getrennt sind.

Hochtemperatursupraleiter in Draht oder Bandform werden in ersten Prototypen von Hochstromkabeln, Transformatoren und Energiespeichern erprobt. Der Betriebsstrom dieser Komponenten als Bestandteil des Stromnetzes ist ein Wechselstrom mit den sich daraus ergebenden Konsequenzen für die Anforderungen an den Stromleiter. Wechselstrombetrieb verursacht spezifische Wechselstromverluste, Hystereseverluste, Wirbelstromverluste im normalleitenden Hüllmaterial des Supraleiters und Kopplungsverluste zwischen den supraleitenden Kernen.

Um Wirbelstromverluste und insbesondere Kopplungsverluste zu reduzieren, muß das zwischen den supraleitenden Kernen befindliche Material einen möglichst hohen elektrischen Widerstand besitzen. Die notwendige Verwendung von Silber oder Silberlegierungen setzt enge Grenzen durch Einsätz einer speziellen Legierung des Silbers den Widerstand zu erhöhen. Möglich ist ein Faktor von maximal einer Größenordnung bei der Anwendungstemperatur von 77 K, verbunden mit dem Nachteil, daß die Legierungskomponenten teilweise aus teuren edlen Metallen wie Palladium, bestehen, die einer kommerziellen ökonomischen Anwendung erhebliche Nachteile bereiten, oder im anderen Fall z. B. AgMg, AgCu auf dem Wege der Festkörperdiffusion mit dem Supraleiter nachteilig chemisch reagieren.

Ein weiterer sehr wesentlicher Aspekt ist die thermische Stabilisierung des Leiters, die durch die Reinsilberhülle ausgezeichnet ist und durch jede Erhöhung des Materialwiderstandes verschlechtert wird.

Somit ist einer Leiterstruktur gefordert, die einerseits im Kontakt mit dem Supraleiterkern die hohe Stabilisierungswirkung des Silbers bietet, andererseits aber zwischen zwei supraleitenden Kernen den Widerstand erhöht. Das wird durch einen komplexeren Leiteraufbau gelöst, indem die Silberhüllen der Einzelleiter des Mehrkernleiters durch eine resistive Materialschicht getrennt werden, eine sogenannte resistive Barriere.

In der Veröffentlichung WO 96/28853 wird beschrieben, wie zur Herstellung eines elektrischen Leiters Werkstücke gebildet werden, von denen jedes einen Kern, einen umschließenden, elektrisch leitenden Mantel und eine diesen umgebende Hülle hat, die zum größten Teil aus einem oxidierbaren Metall besteht und duktil ist. Die Werkstücke werden zu einem Bündel zusammengelegt und gemeinsam durch plastisches Verformen verlängert. Es schließt sich wenigstens eine Wärmebehandlung in sauerstoffhaltiger Umgebung an. Bei der Wärmebehandlung werden die Kerne in eine supraleitende Phase umgewandelt, wodurch das in den Hüllen vorhandene Material zum größten Teil oxidiert und elektrisch isolierend wird. Die isolierenden Hüllen, auch Barrierematerial genannt, unterbinden bei einer daraus gebildeten Wicklung im Wechselstrombetrieb die Wirbelstromausbildung.

Eine Lösung wird in "Reduction of AC losses in Bi2223 tapes by oxide barriers", Y. Huang, et. al., angenommen zur Publikation in Procc. EUCAS Conference, 30.6. - 3.7.1997, Eindhoven, Niederlande, vorgestellt. Das hierbei in den Leiteraufbau eingebrachte Barrierenmaterial ist BaZrO₄, welches ebenfalls als Pulvermantel des Einzelleiters beim Bündelungsprozeß in das Leiterkomposit eingebaut wird. Diese Oxidkeramik ist relativ hart, was offensichtlich zu einer weniger guten Geometrietreue bei der Leiterverformung führt. Die noch niedrigen Transportstromdichten lassen auf eine nicht optimale Sauerstoffdurchlässigkeit schließen. Messungen der Wechselstromverluste der Leiter zeigen den teilweisen Erfolg der Wirkungsweise einer solche Barriere zur Erhöhung des elektrischer Querwiderstands. Anhand der angegebenen Abhängigkeit des Querwiderstandes von der Barrierenschichtdicke wird gezeigt, daß eine erhebliche Restleitfähigkeit nicht ausgeschaltet werden kann.

Daraus ergibt sich die Aufgabe, die der Erfindung zugrunde liegt. Es soll ein wechselstromverlustarmer Mehrkern-Hochtemperatur-Supraleiter mit Silbermatrix hergestellt werden, zwischen dessen Supraleiter-Filamenten ein ausgesprochen hoher elektrischer Widerstand (Querwiderstand) besteht, ohne dafür Einschränkung in den anderen technischen Eigenschaften hinnehmen zu müssen.

Die Aufgabe wird durch einen Supraleiter gemäß den Merkmalen des Anspruchs 1 gelöst.

An die Barriere werden hohe Forderungen gestellt: Sie muß chemisch inert gegenüber einem Glühprozeß des Supraleiters bei T = 810 - 840° C und ca. 100 Stunden Glühzeit sein, passiv bezüglich einer Reaktion mit dem umliegenden Silber und bezüglich einer Diffusion durch das Silber, um sowohl keine Kontamination des Supraleiters zu verursachen, als auch das Barrierenmaterial als physische Struktur zu erhalten. Eine weitere strenge Forderung als Randbedingung an das Barrierenmaterial ist seine Durchlässigkeit für Sauerstoff, zumindest in ähnlichem Ausmaß wie es für Silber der Fall ist. Eine ebenso grundsätzliche Voraussetzung ist, daß dieses Material in den Zwischenfilamentbereich beim Bündelungsprozeß der Einzelleiter in das Außenhüllrohr angebracht werden muß und somit den ganzen Verformungsprozeß des Leiters unter weitgehendem Geometrieerhalt des Komposits überstehen muß. Die notwendige Erfüllung dieser Randbedingungen schränkt die Auswahl möglicher Materialien erheblich ein.

Als Barrierenmaterial ist elektrisch nicht leitendes Strontiumkarbonat SrCO₃, auch unter dem Mineralnamen Strontianit bekannt, ausgewählt. Dieses Material ist ein Bestandteil des Pulvergemisches der Supraleitervorstufe im Zustand vor der Kalzinierungsglühbehandlung, die die Karbonate zersetzt und den Kohlenstoff weitestgehend als CO₂ entfernt.

Dieses Barrierenmaterial hat folgende entscheidenden Vorteile. Der metallische Bestandteil ist ebenfalls im Supraleiter enthalten. Falls eine Diffusion dieser Barrierenkomponente zum Supraleiter stattfindet, ist nur mit sehr geringen oder gar keinen Auswirkungen auf den Supraleiter zu rechnen.

Eine notwendige Voraussetzung ist die sehr hohe chemische Stabilität gegenüber Zersetzung bei hohen Temperaturen. Für das chemische Gleichgewicht gegenüber Sauerstoff sind die Sauerstoffpartialdrücke ausreichend, die durch die Sauerstoffdurchlässigkeit des Silbers am Barrierenmaterial anstehen, um dessen Zersetzung zu verhindern. Die Glühatmosphäre des Supraleiters enthält 8 % Sauerstoff oder mehr und die Durchlässigkeit des Silbers gegenüber Sauerstoff gewährleistet, daß der erforderliche Partialdruck zur Stabilisierung am Ort der Barriere im Medium Silber anliegt. Die Stabilität des Moleküls läßt nicht erwarten, daß eine Diffusion der Molekülkomponenten stattfindet.

Weitere Vorteile liegen im ökonomischen Bereich, das Material ist handelsüblich in der erforderlichen Reinheit und Granularität und gilt aufgrund seiner Stabilität gesundheitlich und bezüglich der Umweltverträglichkeit als vollkommen unbedenklich.

Dieses Barrierematerial ist grundsätzlich geeignet, in beiden derzeit gängigen BSCCO-Supraleitern eingesetzt zu werden, dem Bi(2212)/Ag-Draht (chemisch (Bi oder Pb)₂Sr₂Ca₁Cu₂Oₓ jeweils bekannten mit +/- Abweichungen der Komponenten) oder Band mit der kritischen Temperatur 85 K (Anwendung bei T = 4,2 - ca. 30 K) und dem Bi(2223)/Ag-Band (chemisch (Bi oder Pb)₂Sr₂Ca₂Cu₃Oₓ jeweils mit bekannten +/- Abweichungen der Komponenten) mit kritischer Temperatur 110 K (Anwendung bei T = 4,2 - 77 K).

Die Verwendung eines Karbonats im Gegensatz zu einem Unedelmetall oder einem Oxid ist vorteilhaft, wobei das prinzipiell sehr schädliche Einbringen von Kohlenstoff in den Leiterverbund durch die extrem hohe Stabilität des Materials neutralisiert wird. Vorteil ist ebenfalls, daß der metallische Bestandteil (Sr) der Barriere identisch einer Komponente (Sr) des Supraleiters ist und somit jegliche Kontamination des Supraleiters mit Fremdmetallen ausgeschlossen ist.

Die Härteanpassung des Barrierematerials an das Silber ist deutlich günstiger, da im Gegensatz zu der in Huang et al. dargestellten Konzentration des Materials in einigen Bereichen des Leiterquerschnitts die günstige Tendenz zu einer homogenen Gleichverteilung des Materials zu beobachten ist. Diese Tendenz zur Ausbildung einer lückenlosen Barriere während des Leiterverformungsprozesses ist eine wichtige Grundvoraussetzung, um die Barrierendicke auf einem nötigen Minimum einstellen zu können und dadurch den Supraleiteranteil auf einem möglichst hohen Niveau zu halten. Hohe Supraleitergehalte sind Voraussetzung einer hohen Stromdichte des Leitergesamtquerschnitts und skalieren mit dem ökonomischen Vorteil einer Anwendung supraleitender Komponenten anstelle konventioneller, normalleitender Komponenten.

Eine zweite sehr wichtige Beobachtung ist ein Sinterverhalten der Barriere, wodurch sie kompaktiert wird und weniger Porosität für eine Durchdringung mit Silber anbietet. Diese Kompaktierung stellt einen Volumenreduktionseffekt dar, der sehr vorteilhaft und sehr effektiv die Tendenz des Supraleiters zur Volumenzunahme während seiner Reaktion unterdrücken kann, sogar zur zusätzlichen Verdichtung beiträgt. Als Folge werden schon nach dem ersten Glühschritt mehr als 50 % des möglichen Transportstroms unter Vermeidung der sonst nötigen Kompaktierung durch einen Walzschritt erreicht. Hierdurch eröffnet sich der technische und ökonomische Vorteil, daß in einem optimierten Leiter mit optimierten Glühbedingungen die gesamte Reaktion in einem Glühprozeß erfolgt und nicht wie bisher in zwei Glühbehandlungen mit eingeschobenem Verformungsschritt. In Leitern mit diesem neuen Barrierenmaterial reagiert der Supraleiter in vergleichbarer Geschwindigkeit wie in einem Referenzleiter ohne Barriere. Dies ist ein Beweis, daß die Sauerstoffdurchlässigkeit der Supraleiterhülle nicht wesentlich durch das Anbringen einer Karbonatbarriere beeinflußt wird..

Die chemische Verträglichkeit der Barriere dokumentiert sich durch deren mit einem Sekundärelektronen-Mikroskop und durch energiedispersive Röntgenanalyse (SEM/EDR bzw. engl. SEM/EDX) nachgewiesene unveränderte chemische Zusammensetzung nach der Supraleiterglühbehandlung. Das Barrierenmaterial ist in der verarbeiteten Form, d. h. Reinheit und Granularität kommerziell erhältlich. Es ist ein natürlich vorkommendes Material und wird als untoxisch und unbedenklich angesehen.

Im folgenden wird der Herstellungsprozeß für einen Mehrkern-BSCOO-Hochtemperatur-Supraleiter, in diesem Fall ein 19-Kernleiter kurz beschrieben und damit die Erfindung näher erläutert. Begleitend dazu ist die Zeichnung mit
- Fig. 1: Prinzipzeichnung des Leiteraufbaus und
- Fig. 2: Mikrographien von Anschliffen des Supraleiterbandes.

Pulver des Supraleiterprekursors wird in ein Silberrohr mit 8 mm Außen- und 6 mm Innendurchmesser verfüllt. Nach Verschließen des Rohres wird das Rohr durch Rundhämmern bis 5 mm Außendurchmesser und anschließendem Drahtziehen bis 2,2 mm Außendurchmesser in 10% Querschnitt-Reduktionsschritten verformt. Danach wird der Draht in Sechseckziehsteinen zu einem sechseckigen Querschnitt gezogen mit einer Schlüsselweise von 1,64 mm. Schließlich wird das in Ethanol oder Butanol aufgeschwemmte Strontianatpulver auf Stücke des Sechsecksupraleiterdrahtes aufgebracht, indem der Supraleiterdraht in die Pulverpaste eingetaucht wird.

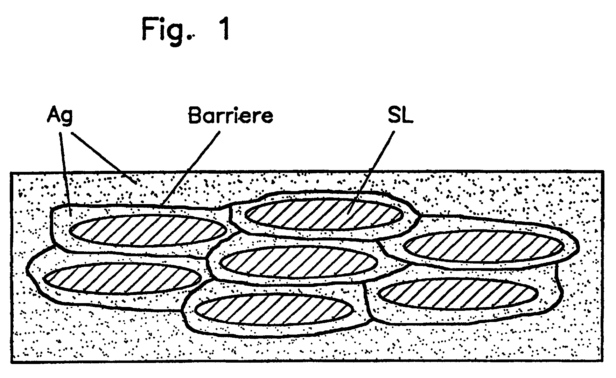

19 solche, nun mit Strontianitpaste umhüllte Supraleiterstücke werden gebündelt und in ein Außenrohr aus Feinsilber mit der Abmessung 12 mm Außendurchmesser und 10 mm Innendurchmesser eingeführt. In Fig. 1 sind der Übersicht halber nur 7 Filamente eingezeichnet.

Durch einen Ausheizprozeß von 1 h unter Vakuum bei 200 - 300° C werden die Alkoholbestandteile entfernt und dann das Rohr verschlossen und der Supraleiterdraht durch Rundhämmern bis zu einem Außendurchmesser von 1,8 mm verformt. Danach wird der Draht mit 10 % Reduktionsschritten in einem Walzgerüst zu einem Band von ca. 2,8 mm Breite und 0,22 mm Dicke verformt.

Zur Reaktion des Supraleiters, d. h. zur Umwandlung der Pulvervorstufe der Supraleiterkerne in die gewünschte Bi(2223)-Phase, wird das Band einer Glühbehandlung von 30 h bei 818° C in einer Glühatmosphäre von 8 % Sauerstoff/Argon geglüht. Nach dem Glühprozeß ist der Bandquerschnitt vorteilhafterweise unverändert.

Eine Reduktion der Banddicke um ca. 5 - 10% ist der Auswirkung des Dichtsinterns der SrCO₃-Barriere zuzuschreiben.

Der Transportstrom des Supraleiterbandes wird mit der 4-Punkt-Methode und einem Kriterium für den kritischen Strom von 1 µV/cm zu 13,7 A bestimmt. Mit den aus optischen Mikrographien bestimmten Querschnitten der Supraleiterkerne im Supraleiterband wird die Stromdichte zu 11 kA/cm² bestimmt. Dieser Wert stellt für die Grundqualität des verwendeten Supraleiterpulvers ca. 50 % des erreichbaren Stromes vergleichbarer Standardleiter dar. Für die Durchführung von nur einem Glühschritt ist der Wert hoch. Eine Erklärung für diesen Effekt ist das Zusammensintern des Barrierenmaterials, welches dadurch eine Verdichtung des Filamentmaterials verursacht wird. Dadurch bleibt der sonst nötige Walzschritt zur Filamentverdichtung, der zwischen der üblicherweise in zwei oder drei Glühschritte aufgeteilten Prozedur angewandt wird, teilweise erspart.

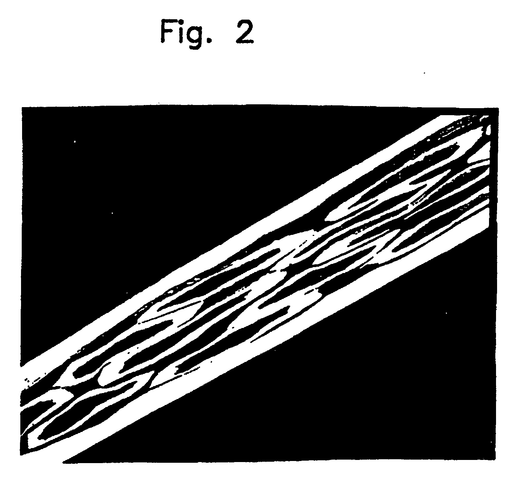

Die Konstitution der Barriere vor und nach dem Glühprozeß wird mit dem energiedispersiven Röntgenanalyse-Verfahren (EDX) kontrolliert. Fig. 2 zeigt die mit einem optischen Mikroskop aufgenommenen Mikrographien des Anschliffs eines derartig hergestellten Supraleiters, wobei sich die resistive Barriere in Form der geschlossenen Linien um den jeweiligen Kern erkennen läßt.

## Patentansprüche

1. Mehrkern-BSCCO-Hochtemperatur-Supraleiter, bei dem die jeweils silberumhüllten Supraleiter-Filamente durch eine resistive Barriereschicht voneinander getrennt sind,
**dadurch gekennzeichnet, daß**
die resistive Barriereschicht aus einem Karbonat besteht, der metallische Bestandteil des Karbonats identisch mit einer Komponente des Supraleiter-Materials ist.

2. Mehrkern-Hochtemperatur-Supraleiter nach Anspruch 1,
**dadurch gekennzeichnet, daß**
die Einzelkern-Supraleiter vor der Bündelung und damit vor dem Verformungsprozeß mit dem Karbonat umgeben werden.

3. Mehrkern-Hochtemperatur-Supraleiter nach Anspruch 2,
**dadurch gekennzeichnet, daß**
die resistive Barriereschicht chemisch inert gegenüber dem Glühprozeß des Supraleiters ist.

4. Mehrkern-Hochtemperatur-Supraleiter nach Anspruch 3,
**dadurch gekennzeichnet, daß**
die resistive Barriereschicht ähnlich sauerstoffdurchlässig wie Silber ist.

5. Mehrkern-Hochtemperatur-Supraleiter nach Anspruch 4,
**dadurch gekennzeichnet, daß**
das Supraleiter-Material BSCCO und die resistive Barriereschicht aus Strontiumkarbonat (SrCO₃) ist.

## Claims

1. Multi-core BSCCO high-temperature superconductor in which the silver-clad superconductor filaments are separated by a resistive barrier layer, with the resistive barrier layer consisting of a carbonate whose metal component is identical to the component of the superconductor material.

2. Multi-core high-temperature superconductor as claimed in Claim 1 above, with the single-core superconductors enclosed in the carbonate prior to bundling and, thus, prior to the deformation process.

3. Multi-core high-temperature superconductor as claimed in Claim 2 above, with the resistive barrier layer chemically inert to the annealing process of the superconductor.

4. Multi-core high-temperature superconductor as claimed in Claim 3 above, with the resistive barrier layer permeable to oxygen very much like silver.

5. Multi-core high-temperature superconductor as claimed in Claim 4 above, with BSCCO as the superconductor material and strontium carbonate (SrCO₃) as the resistive barrier layer.

## Revendications

1. Supraconducteur à haute température à plusieurs noyaux BSCCO, selon lequel on sépare les uns des autres les filaments supraconducteurs chacun gainés d'argent par une couche résistante formant barrière,
**caractérisé en ce que**
la couche résistante formant barrière est un carbonate, la composante métallique du carbonate étant identique à une composante de la matière supraconductrice.

2. Supraconducteur à plusieurs noyaux à haute température selon la revendication 1,
**caractérisé en ce que**
les différents noyaux supraconducteurs sont entourés du carbonate avant d'être regroupés et avant l'opération de mise en forme.

3. Supraconducteur à plusieurs noyaux à haute température selon la revendication 2,
**caractérisé en ce que**
la couche barrière résistante est chimiquement inerte par rapport au procédé de recuit du supraconducteur.

4. Supraconducteur à plusieurs noyaux à haute température selon la revendication 3,
**caractérisé en ce que**
la couche barrière résistante a une perméabilité à l'oxygène analogue à celle de l'argent.

5. Supraconducteur à plusieurs noyaux à haute température selon la revendication 4,
**caractérisé en ce que**
la matière supraconductrice BSCCO et la couche barrière résistante sont en carbonate de Strontium (SrCo₃).
